(19) Europäisches Patentamt
European Patent Office
Office européen des brevets

(11) Publication number: 0 174 249 B1

# (12) EUROPEAN PATENT SPECIFICATION

(45) Date of publication of patent specification: 28.12.88

(51) Int. Cl.$^4$: C 23 F 1/12

(21) Application number: 85401676.3

(22) Date of filing: 23.08.85

## (54) A dry etching method for a chromium or chromium oxide film.

(30) Priority: 24.08.84 JP 175070/84

(43) Date of publication of application:
12.03.86 Bulletin 86/11

(45) Publication of the grant of the patent:
28.12.88 Bulletin 88/52

(84) Designated Contracting States:
DE FR GB

(56) References cited:
US-A-3 951 709
US-A-4 445 966

PATENT ABSTRACTS OF JAPAN, unexamined applications, C field, vol. 7, no. 213, September 20, 1983, THE PATENT OFFICE JAPANESE GOVERNMENT, p. 46 C 187

PATENT ABSTRACTS OF JAPAN, unexamined applications, C field, vol. 7, no. 91, April 15, 1983, THE PATENT OFFICE JAPANESE GOVERNMENT, p. 95 C 162

(73) Proprietor: FUJITSU LIMITED
1015, Kamikodanaka Nakahara-ku
Kawasaki-shi Kanagawa 211 (JP)

(72) Inventor: Hoshino, Eiichi
4-13-102, Denenchofu 2 chome
Ohta-ku Tokyo 145 (JP)

(74) Representative: Descourtieux, Philippe et al
CABINET BEAU de LOMENIE 55 rue d'Amsterdam
F-75008 Paris (FR)

(56) References cited:
PATENT ABSTRACTS OF JAPAN, unexamined applications, C field, vol. 6, no. 158, August 19, 1982, THE PATENT OFFICE JAPANESE GOVERNMENT, p. 59 C 120

EP 0 174 249 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Background of the invention

This invention relates to a dry-etching method for a chromium (Cr) or chromium oxide film, and more particularly to a method using an etchant gas in the dry etching of the film.

Cr thin film is a material indispensable to the masks used for generating precision patterns in IC chips today. Such Cr film is generally subjected to a photo-lithographic process or, according to a more recent technology, to an electron-beam lithographic process. The Cr film has conventionally been selectively etched off by using a wet process for developing the final pattern. However, dry etching processes are going to be employed instead of the wet process, in order to provide finer patterns and to simplify the etching process of the Cr films.

In the dry etching of Cr film, an etchant gas containing halide of a hydrocarbon, for example, $CCl_4$, and oxygen is generally used. The etching mechanism involved in the dry etching is considered to be very complicated but it is believed that dominant process is a kind of reactive sputtering. The Cr or Cr-oxide film is removed by forming a chromyl halide having relatively high vapor pressure such as chromyl chloride ($CrO_2Cl_2$) through a chemical reaction with a halogen-containing etchant gas such as $CCl_4$ accompanied by oxygen gas. A likely chemical reaction between the Cr film and the etchant gas is shown in the following.

$$2Cr+CCl_4+3O_2=2CrO_2Cl_2+CO_2 \quad (1)$$

However, $CrO_2Cl_2$ is an unstable compound and the reverse reaction toward left side in the above equation can not be neglected. As a result, Cr atoms released by the decomposition form a deposit on the Cr film to be etched. Therefore, the etching rate data for a Cr film is usually small compared with other materials such as silicon. As mentioned above, the dry etching mechanism is complicated. Accordingly, the rate of reverse reaction forming Cr atoms through the decomposition of $CrO_2Cl_2$ seems very fluctuating depending upon the reaction conditions. Therefore, extremely precise control for the reaction condition is needed in order to obtain reproducible results of etching rate of the Cr film. The controlled factors involved in this sense include partial pressures and flow rates of respective constituents in the etchant gas, input power for generating plasma of the etchant gas, exhausting velocity of pumping system in the dry etching system, etc. Moreover, there are further unknown factors decreasing the reproducibility.

Besides, the etching rate of a resist film is generally higher than that of Cr to the etchant gas as described above. This means that a resist mask film of relatively larger thickness is needed for patterning the Cr film. The low etching rate of Cr film results in a long etching time and causes pattern deformation in the masking resist film by a temperature rise during the etching period. And further, the necessarily large thickness of the resist film inevitably leads to a poor accuracy of pattern formed in the resist film. These problems are particularly crucial in the resist films sensitive to electron beam exposure, because their chemical and physical stabilities in dry etching circumference are low compared with photo-sensitive resist film.

Summary of the invention

It is an object of the present invention to provide a dry etching method having a higher etching rate for a Cr or Cr-oxide film.

It is another object of the present invention to provide a dry etching method having improved reproducibility for a Cr or Cr-oxyde film.

It is still another object of the present invention to provide a dry etching method suitable to a condition where a resist film sensitive to electron beam exposure is used for masking a Cr or Cr-oxyde film.

The above object can be attained by a dry etching, method for a chromium (Cr) or Cr-oxyde film in which the film is submitted to a plasma containing vapors of halide of hydrocarbon, characterized in that it comprises a step of subjecting a Cr or Cr-oxyde film to a plasma of a gas mixture containing respective vapours of a halide of hydrocarbon and an alcohol selected from a group consisting of $CH_3OH$ and $C_2H_5OH$.

Other features and advantages of the present invention will become apparent from reading the following description and claims taken in connection with the accompanying drawings, forming a part of this application, in which:

Brief description of the drawings

Figure 1 is a cross-section of the reaction chamber in the dry etching system used for embodying the present invention;

Figure 2 is a graph showing the relation between etched depth in a Cr film and etching time in case of addition of ethyl alcohol vapor to an etchant gas; and

Figure 3 is a graph showing the relation between etched depth in a Cr film and etching time in case of addition of methyl alcohol vapor to an etchant gas.

Description of preferred embodiments

According to equation (1), the inventor noted that the etching rate of a Cr film can be increased if the reaction product of $CrO_2Cl_2$ or $CO_2$ is removed from the chemical reaction system soon after it is formed.

Thus ethyl alcohol or ethanol ($C_2H_5OH$) vapor was added as a reducing agent for $CrO_2Cl_2$ to an etchant gas atmosphere containing $CCl_4$ vapor and oxygen gas. The result showed a drastic effect of the addition of ethyl alcohol as described in the following.

Figure 1 is a cross-section of the reaction chamber in the dry etching system used for embodying the present invention. A pair of parallel electrodes comprising an anode 2 and a cathode 3, an etchant gas inlet pipe 4 and another inlet pipe 5 for introducing an additive component such as ethyl alcohol vapor are arranged in a reaction chamber 1. The cathode 3 is electrically insulated from the reaction chamber 1 by a ceramic or fluorocarbon plastics insulating material 7. A substrate 6 having a Cr film which is coated with a resistive film is placed on the cathode 3. The resist film has been selectively exposed to an electron beam for delineating a predetermined pattern thereon and has then been subjected to a developing process with which the resist film on the portion of the Cr film to be etched off by subsequent dry etching is removed. In Figure 1, RF and VAC indicate a radio frequency power source and a vacuum exhausting system, respectively.

During the dry etching process, an etchant gas and alcohol vapor are respectively introduced into the reaction chamber 1 from the inlet pipes 4 and 5 at respective predetermined flow rates. The pressure in the reaction chamber 1 is kept at a predetermined value by controlling the exhausting velocity of the vacuum system. A discharge of the etchant gas is caused between the anode 2 and cathode 3 by the radio frequency power, and a plasma of the etchant gas is generated. Thus the naked portion of the Cr film on the substrate 6 is exposed to the plasma, and dry etched according to the chemical reaction as expressed by equation (1).

Figure 2 is a graph showing the relation between etched depth in a Cr film and etching time in case of addition of ethyl alcohol vapor to an etchant gas containing $CCl_4$ and oxygen. Such a relation is obtained at several flow rates of ethyl alcohol vapor added to the dry etching atmosphere. Experimental conditions established for obtaining the curves in Figure 2 are as follows:

| | |
|---|---|
| Cr film thickness | 1000 Å |
| Etchant gas mixture and flow rate | $CCl_4$ 19 SCCM* |
| | 02 60 SCCM* |
| Total pressure | 0.3 Torr |
| Input radio frequency and power | 13.56 MHz, 75W |
| Anode-cathode distance | 40 mm |
| Substrate temperature: | 10°C |

* SCCM: standard cubic centimeter per minute. The etched depth measurement of the Cr film was carried out by means of a tracer method using a contacting stylus (Alpha-STEP 200, Tencor Inc. U.S.A.).

As shown in Figure 2, the dry etched depth increase in a Cr film is constant during etching time up to 120 minutes in case without addition of ethyl alcohol vapor to the etchant gas atmosphere, showing an average etching rate of about 190 Å/min. On the other hand, larger dry etched depth increase is observed in case of addition of ethyl alcohol vapor at flow rates of 12, 20 and 29 SCCM. Corresponding etching rate for the addition of ethyl alcohol of 12 SCCM flow rate is about 695 Å/min in average. The addition of ethyl alcohol of flow rate in the range from 20 to 29 SCCM shows a further larger etching rate together with a kind of induction period prior to the steep increase in the rate as shown in Figure 2. The saturation tendency of the curves for 20 SCCM and 29 SCCM is due to the final stage of the dry etching of the Cr film wherein it has been observed that the surface of the substrate began to be exposed.

According to the above experiment, etching rate of a Cr film can be increased approximately three times by adding ethyl alcohol vapor at a flow rate of 12 SCCM to an etchant gas containing $CCl_4$ and oxygen. Further larger etching rate increase is revealed with a steep gradient in the curves for addition of ethyl alcohol vapor of both of 20 and 29 SCCM flow rates as shown in Figure 2. The dry etching rate increase may be larger three times or more compared with the rate at a conventional dry etching condition. According to the above results, the time necessary to etch off a Cr film can be reduced into one third or more, therefore, the pattern accuracy degradation due to the resist film deformation by temperature rise during the dry etching process can be eliminated.

In the above embodiment, the amount of addition of ethyl alcohol has been changed in the range of 12 to 29 SCCM because of the limitation of flow meter. However, a preliminary experiment using a different dry etching apparatus has shown similar dry etching rate increase by the addition of ethyl alcohol vapor at a smaller flow rate such as in the range of five to 10 SCCM. The etchant gas and other experimental conditions in that case are as follows:

| | |
|---|---|
| Cr film thickness | 1400 Å |
| Etchant gas mixture and flow rate | $CCl_4$ 100 SCCM |
| | $O_2$ 70 SCCM |
| Total pressure | 0.4 Torr |
| Input radio frequency and power | 13.56 MHz, 500 W |

According to the above embodiment and preliminary experiment results, it is reasonable to define the preferable amount of ethyl alcohol additive to the etchant gas mixture on the basis of flow rate ratio of ethyl

alcohol to the etchant gas mixture, in particular to the flow rate of the halide gas component such as $CCl_4$. This is because the total pressure of the dry etching atmosphere is the dominant factor and the flow rates of ethyl alcohol vapor and the etchant gas mixture to achieve an appropriate total pressure differ largely according to the individual dry etching apparatus employed. According to the above results, it can be said that a preferable flow rate ratio of ethyl alcohol vapor to the halide gas component is approximately in the range of 0.05 to 1.53. It is obvious that the present invention is not strictly limited to this range.

The dry etching rate increase with addition of ethyl alcohol can be attributed to the reduction of $CrO_2Cl_2$ by ethyl alcohol according to a chemical reaction shown below.

$$4CrO_2Cl_2+CCl_4+C_2H_5OH=4CrCl_3+3CO_2+3H_2O \quad (2)$$

According to equation (2), valence value six of Cr in $CrO_2Cl_2$ is reduced to three in $CrCl_3$, showing chemical reduction reaction by ethyl alcohol.

Equation (2) suggests that addition of vapor of other kind of alcohols seems to be effective as well as ethyl alcohol. This has been confirmed on methyl alcohol or methanol ($CH_3OH$) as described below.

Figure 3 is a graph showing the relation between etched depth in a Cr film and etching time in case of addition of methyl alcohol vapor to an etchant gas containing $CCl_4$ and oxygen. Experimental conditions established for obtaining the curves in Figure 3 are the same as those for the curves in Figure 2. In Figure 3, each solid line indicates the change of etched depth in a Cr film as a function of etching time. Such dry etching test has been carried out on a resist film concurrently with the Cr film and the result is plotted in broken lines in Figure 3.

As shown in Figure 3, etching rate of a Cr film is increased from about 230 Å/min for the etchant gas without addition of methyl alcohol vapor to about 690 Å/min for the etchant gas with addition of methyl alcohol vapor at flow rate of 12 SCCM. That is the dry etching rate of a Cr film is increased three times by the addition of methyl alcohol vapor. On the other hand, etching rate of the resist film reveals only slight change with the addition of methyl alcohol vapor, providing about 1040 Å/min for the etchant gas with addition of methyl alcohol vapor and about 1000 Å/min for the etchant gas without addition of methyl alcohol vapor. Accordingly, dry etching selectivity (ratio of etching rate of the Cr film to that of the resist film) is increased from 0.23 for the case without addition of methyl alcohol vapor to 0.64 for the case with addition of methyl alcohol vapor. Such increase in the dry etching selectivity permits to reduce necessary thickness of the resist film and is advantageous for increasing the accuracy of pattern generated in the Cr film. For the addition of methyl alcohol vapor, the preferable flow rate ratio can be assumed in the same range as mentioned with reference to the embodiment using the ethyl alcohol additive.

Experimental result obtained by addition of n- or iso-propyl alcohol vapor has not revealed any improvement in the dry etching rate of a Cr film. The reason for such no positive effect in the addition of the propyl alcohols has not been made clear as yet. However, the large cross-section of propyl alcohol molecules could be attributed to a cause of reducing the life time of halogen radicals in the plasma, and hence, to the decrease in the apparent dry etching rate.

Many of theories introduced into the above discussion should be regarded as tentative ones. Regardless of the theories, the dry etching method according to the present invention has shown excellent results.

As shown in Figure 1, the inlet pipe 5 for ethyl alcohol vapor is installed apart from the inlet pipe 4 for etchant gas of the mixture of oxygen gas and halide of hydrocarbon vapor. This is intended to reduce probability of direct reaction between oxygen gas and ethyl alcohol vapor.

A Cr-film mask used for generating patterns on IC chips by using photo-lithographic processes is usually provided with an anti-reflective film of, for example, chromium oxide, $Cr_2O_3$, having a thickness of about 200Å. The Cr-oxide film is subsequently formed on a metallic Cr film, and then, subjected to a dry etching process for generating a predetermined pattern together with the underlying Cr film, in general. Therefore, it is obvious to those in the art that the above embodiment can be effectively applied to such Cr-oxide film on a Cr film.

Considering the mechanism for increasing the dry etching rate of Cr film as explained with reference to equation (2), it is also obvious to those in the art that the addition of ethyl or methyl alcohol vapor can improve the dry etching rate using an etchant gas containing one of halides of hydrocarbons such as $CF_4$ (carbon tetrafluoride), $CH_3CCl_3$ (methyl-trichloromethane), $C_2Cl_4$ (tetrachloro-ethylene) and $C_2H_2Cl_2$ (dichloro-ethylene).

## Claims

1. A dry etching method for a chromium (Cr) or Cr-oxyde film in which the film is submitted to a plasma containing vapors of halide of hydrocarbon, characterized in that it comprises a step of subjecting a Cr or Cr-oxyde film to a plasma of a gas mixture containing respective vapors of a halide of hydrocarbon and an alcohol selected from a group consisting of $CH_3OH$ and $C_2H_5OH$.

2. A dry etching method as set forth in Claim 1, characterized in that said halide is a chloride.

3. A dry etching method as set forth in Claim 1, characterized in that said halide is a fluoride.

4. A dry etching method as set forth in Claim 2, characterized in that said chloride is selected from a group consisting of $CCl_4$, $C_2Cl_4$ and $C_2H_2Cl_2$.

5. A dry etching method as set forth in Claim 3, characterized in that said fluoride is $CF_4$.

6. A dry etching method as set forth in Claim 1, characterized in that said halide vapor and said alcohol vapor are respectively introduced into a chamber (1) through individual inlets (4, 5) and in that said plasma is generated therein.

7. A dry etching method as set forth in Claim 1, characterized in that said Cr or Cr-oxyde film is selectively masked with a resist layer.

8. A dry etching method as set forth in Claim 1, characterized in that said gas mixture includes oxygen gas.

**Patentansprüche**

1. Verfahren zum Trockenätzen eines Films aus Chrom (Cr) oder Cr-oxid, bei dem der Film einem Plasma ausgesetzt wird, das Dämpfe von Kohlenwasserstoff-Halogenid enthält, gekennzeichnet, durch einen Verfahrenschritt bei dem ein Cr- oder Cr-oxidfilm einem Plasma einer Gasmischung ausgesetzt wird, die jeweils Dämpfe eines Kohlenwasserstoff-Halogenids und eines Alkohols enthält, der aus der Gruppe von $CH_3OH$ und $C_2H_5OH$ ausgewählt ist.

2. Trockenätzverfahren nach Anspruch 1, dadurch gekennzeichnet, dass das Halogenid ein Chlorid ist.

3. Trockenätzverfahren nach Anspruch 1, dadurch gekennzeichnet, dass das Halogenid ein Fluorid ist.

4. Trockenätzverfahren nach Anspruch 2, dadurch gekennzeichnet, dass das genannte Chlorid aus einer Gruppe ausgewählt ist, die aus $CCl_4$, $C_2Cl_4$ und $C_2H_2Cl_2$ besteht.

5. Trockenätzverfahren nach Anspruch 3, dadurch gekennzeichnet, dass das genannte Fluorid $CF_4$ ist.

6. Trockenätzverfahren nach Anspruch 1, dadurch gekennzeichnet, dass der genannte Halogeniddampf und der genannte Alkoholdampf jeweils durch individuelle Einlässe (4, 5) in eine Kammer (1) eingeführt werden und dass das genannte Plasma darin erzeugt wird.

7. Trockenätzverfahren nach Anspruch 1, dadurch gekennzeichnet, dass der genannte Cr- oder Cr-oxidfilm mit einer Resistschicht selektiv maskiert wird.

8. Trockenätzverfahren nach Anspruch 1, dadurch gekennzeichnet, dass die genannte Gasmischung Sauerstoff- gas enthält.

**Revendications**

1. Procédé d'incision à sec d'une pellicule de chrome (Cr) ou d'une pellicule d'oxyde de Cr, dans lequel on soumet la pellicule à un plasma contenant des vapeurs d'halogénure d'hydrocarbure, caractérisé en ce qu'il comprend l'opération consistant à soumettre une pellicule de Cr ou d'oxyde de Cr à un plasma d'un mélange gazeux contenant les vapeurs respectives d'un halogénure d'hydrocarbure et d'un alcool choisi dans le groupe constitué de $CH_3OH$ et $C_2H_5OH$.

2. Procédé d'incision à sec selon la revendication 1, caractérisé en ce que ledit halogénure est un chlorure.

3. Procédé d'incision à sec selon la revendication 1, caractérisé en ce que ledit halogénure est un fluorure.

4. Procédé d'incision à sec selon la revendication 2, caractérisé en ce que ledit chlorure est choisi dans un groupe constitué de $CCl_4$, $C_2Cl_4$ et $C_2H_2Cl_2$.

5. Procédé d'incision à sec selon la revendication 3, caractérisé en ce que ledit fluorure est $CF_4$.

6. Procédé d'incision à sec selon la revendication 1, caractérisé en ce que l'on introduit respectivement ladite vapeur d'halogénure et ladite vapeur d'alcool dans une chambre (1) par l'intermédiaire d'entrées distinctes (4, 5) et en ce que ledit plasma y est créé.

7. Procédé d'incision à sec selon la revendication 1, caractérisé en ce qu'on masque sélectivement ladite pellicule de Cr ou d'oxyde de Cr à l'aide d'une couche d'agent sensible du type réserve.

8. Procédé d'incision à sec selon la revendication 1, caractérisé en ce que ledit mélange de gaz contient de l'oxygène gazeux.

FIG.1

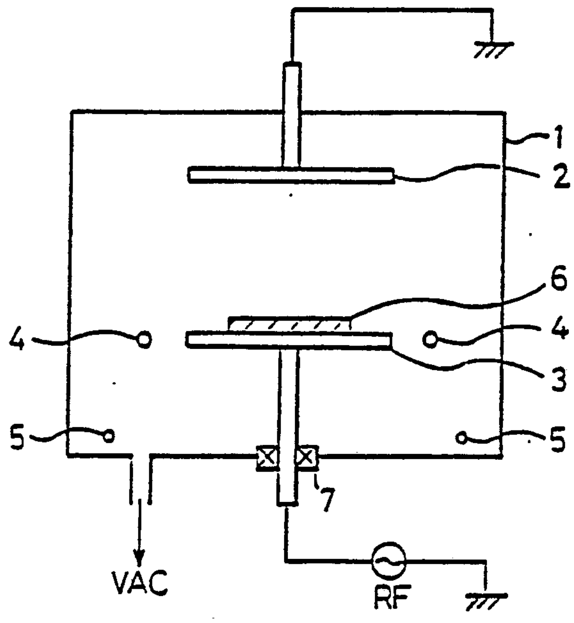
1
2
6
4
4
3
5
5
7
VAC
RF

FIG.2

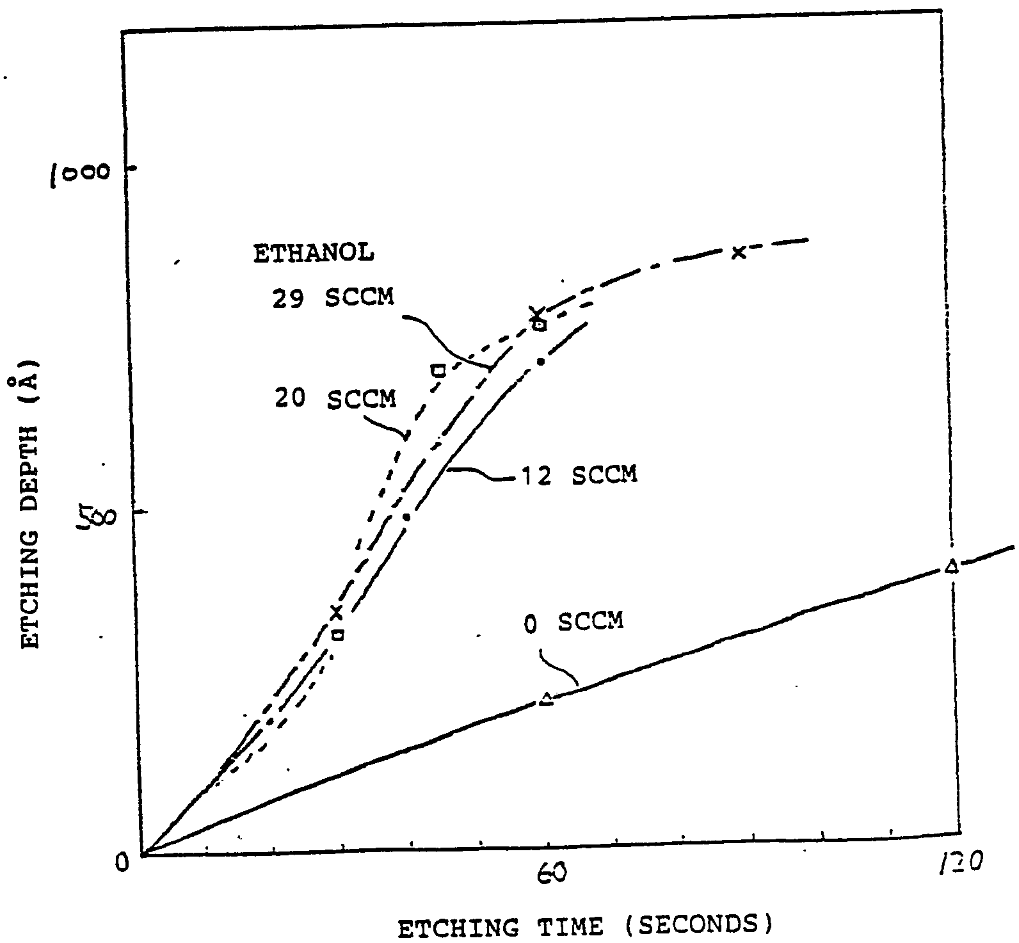
1000
500
0
60
120
ETCHING DEPTH (Å)
ETCHING TIME (SECONDS)
ETHANOL
29 SCCM
20 SCCM
12 SCCM
0 SCCM

FIG. 3

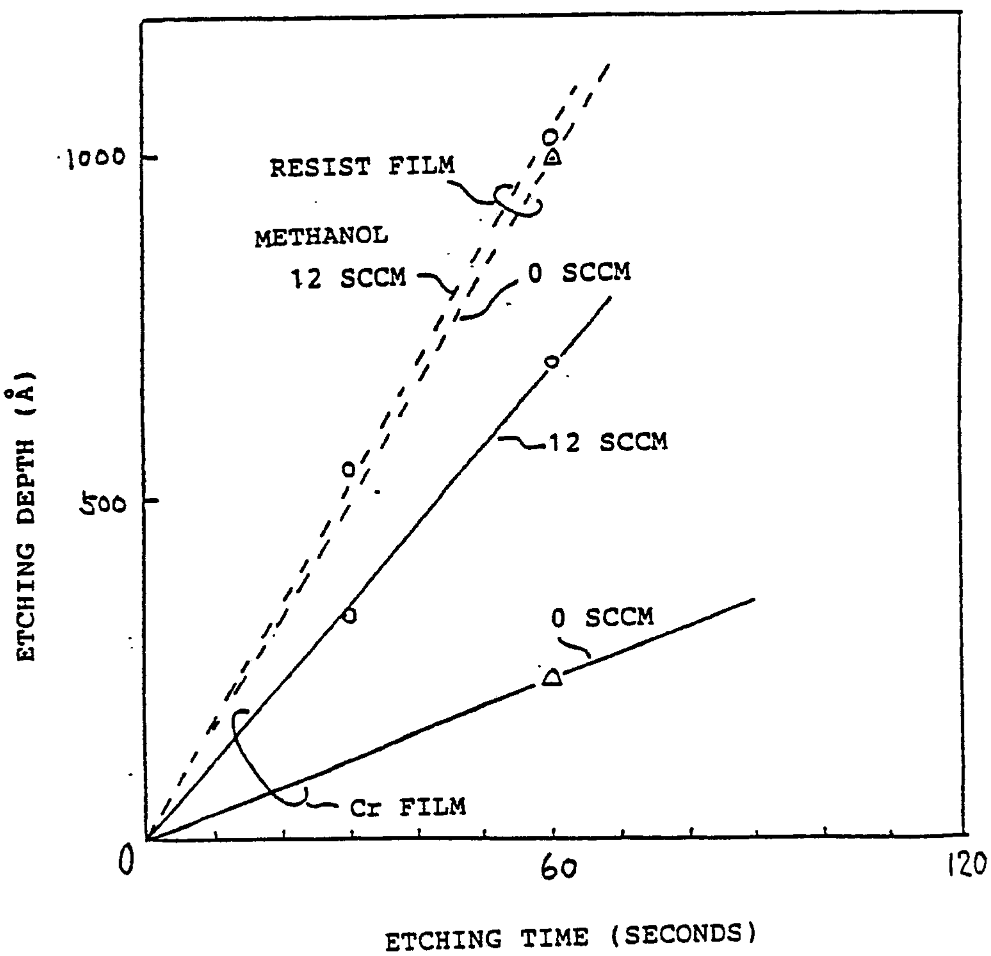
RESIST FILM
METHANOL
12 SCCM
0 SCCM
12 SCCM
0 SCCM
Cr FILM
ETCHING DEPTH (Å)
1000
500
0
60
120
ETCHING TIME (SECONDS)